# EUROPEAN PATENT APPLICATION

(11) **EP 4 803 476 A1**
(43) Date of publication of application: **09.09.2026**
(21) Application number: 24885670.0
(22) Date of filing: 28.10.2024
(51) Int. Cl.: B81B 1/00, B81C 1/00, G01N 1/10, G01N 33/48

(54) **FLOW PATH DEVICE AND METHOD FOR MANUFACTURING SAME**

(30) Priority: 30.10.2023 JP 2023185166
(71) Applicant: NOK Corporation, Minato-ku Tokyo 105-8585 (JP); The University of Tokyo, Bunkyo-ku, Tokyo 113-8654 (JP)
(72) Inventor: UEDA Keisuke, Fujisawa-shi, Kanagawa 251-0042 (JP); KIM Soohyeon, Tokyo 153-8904 (JP)
(74) Representative: Global IP Europe Patentanwaltskanzlei
(86) International application number: PCT/JP2024/038380
(87) International publication number: WO 2025/094897

(57) **Abstract**

A flow path device (1) includes: a base (4) having a first surface (4a) and a second surface (4b) facing away from each other; and a pair of a first electrode (10) and a second electrode (11). The base (4) has a flow path (7) extending along the first surface (4a) and the second surface (4b), and the pair of the first electrode (10) and the second electrode (11) form an electric field intersecting the flow path (7) along a direction in which the first surface (4a) and the second surface (4b) face away.

## Description

### TECHNICAL FIELD

The present invention relates to a flow path device and a method of manufacturing the same.

### BACKGROUND ART

Non-Patent Literature 1 discloses, for example, a device for separating by a specific microparticle such as a cell from other microparticles by a dielectrophoretic effect. In the device, a sample solution in which microparticles are suspended is flowed through a flow path formed in a glass substrate. When an alternating voltage is applied to a plurality of pairs of electrodes adjacent to the flow path, an electric field is formed in the flow path between each adjacent pair of electrodes. The electric field causes an attractive force (a positive dielectrophoresis) or a repulsive force (a negative dielectrophoresis) to be exerted on the microparticles. As a result, the specific microparticle is separated from other microparticles.

### CITATION LIST

### NON-PATENT LITERRATURE

[Non-Patent Literature 1] Niccolo Piacentini et al., "Separation of platelets from other blood cells in continuous-flow by dielectrophoresis field-flow-fractionation", Biomicrofluidics., September 21, 2011, 5(3): 034122-034122-8

### SUMMARY

### TECHINICAL PROBLEM

According to Non-Patent Literature 1, the electrodes are planar electrodes in which a plurality of pairs of electrodes are formed along a surface of a glass substrate. The planar electrodes form an electric field intersecting the flow path along the front surface of the glass substrate. The electric field is formed only between each adjacent pair of electrodes. Since a distance between each adjacent pair of electrodes is limited, a range over which the electric field is exerted is restricted. Therefore, if the flow velocity of the sample solution is high, the microparticles fail to be sufficiently separated. In contrast, if the flow velocity is low, the throughput of the device decreases.

### SOLUTION TO PROBLEM

Accordingly, an object of the present invention is to provide a flow path device and a method of manufacturing the same capable of forming an electric field over a long range along a flow path.

A flow path device according to a first aspect of the present invention includes: a base having a first surface and a second surface facing away from each other; and a pair of a first electrode and a second electrode, in which the base has a flow path extending along the first surface and the second surface, and the pair of the first electrode and the second electrode form an electric field intersecting the flow path along a direction in which the first surface and the second surface face away.

In the flow path device according to the first aspect, the first electrode extends along the flow path on a side of the first surface, and the second electrode extends along the flow path on a side of the second surface.

In the flow path device according to the first aspect, the first electrode is formed on the first surface and faces the flow path, and the second electrode is formed on the second surface and faces the flow path.

The flow path device according to the first aspect of the present invention includes: a third electrode formed on the first surface, the third electrode facing the flow path while being opposed to the first electrode with the flow path in between; and a fourth electrode formed on the second surface, the fourth electrode facing the flow path while being opposed to the second electrode with the flow path in between.

The flow path device according to the first aspect of the present invention includes: a first covering member provided on the first surface to cover the flow path; and a second covering member provided on the second surface to cover the flow path.

In the flow path device according to the first aspect, the flow path includes a first flow path portion extending linearly.

In the flow path device according to the first aspect, the flow path includes a first flow path portion extending linearly, and a pair of second flow path portions branched from the first flow path portion.

In the flow path device according to the first aspect, the flow path is exposed on each of the first surface and the second surface of the base.

In the flow path device according to the first aspect, the base and the pair of the first electrode and the second electrode provide a flexible printed circuit board.

A method of manufacturing a flow path device according to a second aspect of the present invention includes: forming a first conductive region on a first surface of a base, the base having the first surface and a second surface; forming a second conductive region on the second surface at a position corresponding to the first conductive region; and cutting out a flow path in the base at the first conductive region and the second conductive region, in which by the cutting out of the flow path, a first electrode facing the flow path is formed on the first surface of the base and a second electrode facing the flow path is formed on the second surface.

In the method of manufacturing a flow path device according to the second aspect, by the cutting out of the flow path, a third electrode and a fourth electrode are formed on the first surface of the base and the second surface of the base, respectively, the third electrode facing the flow path while being opposed to the first electrode with the flow path in between, the fourth electrode facing the flow path while being opposed to the second electrode with the flow path in between.

In the method of manufacturing a flow path device according to the second aspect, the cutting out of the flow path is performed by laser beam irradiation.

### ADVANTAGEOUS EFFECTS OF THE INVENTION

According to the present invention, it is possible to provide a flow path device and a method of manufacturing the same capable of forming an electric field over a long range along a flow path.

### BRIEF DESCRIPTION OF THE DRAWINGS

Fig. 1 is a perspective view schematically illustrating a structure of a flow path device 1 according to a first embodiment of the present invention.
Fig. 2 is a plan view schematically illustrating the structure of the flow path device 1 according to the first embodiment of the present invention.
Fig. 3 is an exploded perspective view schematically illustrating the structure of the flow path device 1 according to the first embodiment of the present invention.
Fig. 4 is a perspective view of a base 4 alone as viewed from a back surface side of the base 4.
Fig. 5 is an end view of a cross section taken along a 5-5 line in Fig. 2.
Fig. 6 is a partial enlarged cross-sectional view of the flow path device 1, schematically illustrating an appearance of an electric field formed in a flow path 7.
Fig. 7 is a cross-sectional view taken along a line 7-7 in Fig. 6.
Fig. 8 schematically illustrates a method of manufacturing the flow path device 1 according to an embodiment of the present invention.
Fig. 9 schematically illustrates the method of manufacturing the flow path device 1 according to an embodiment of the present invention.
Fig. 10 is a plan view schematically illustrating a structure of a flow path device 1A according to a second embodiment of the present invention.
Fig. 11 is an end view of a cross section taken along an 11-11 line in Fig. 10.
Fig. 12 is a partial enlarged cross-sectional view of the flow path device 1A, schematically illustrating an appearance of an electric field formed in a flow path 7A.
Fig. 13 is a plan view schematically illustrating a structure of a flow path device 1B according to a third embodiment of the present invention.

### DESCRIPTION OF THE EMBODIMENTS

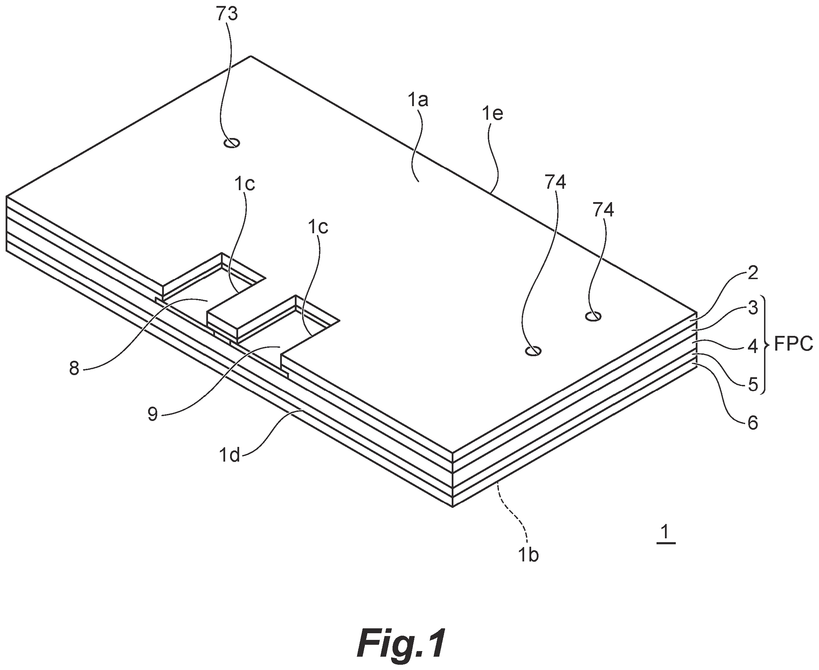

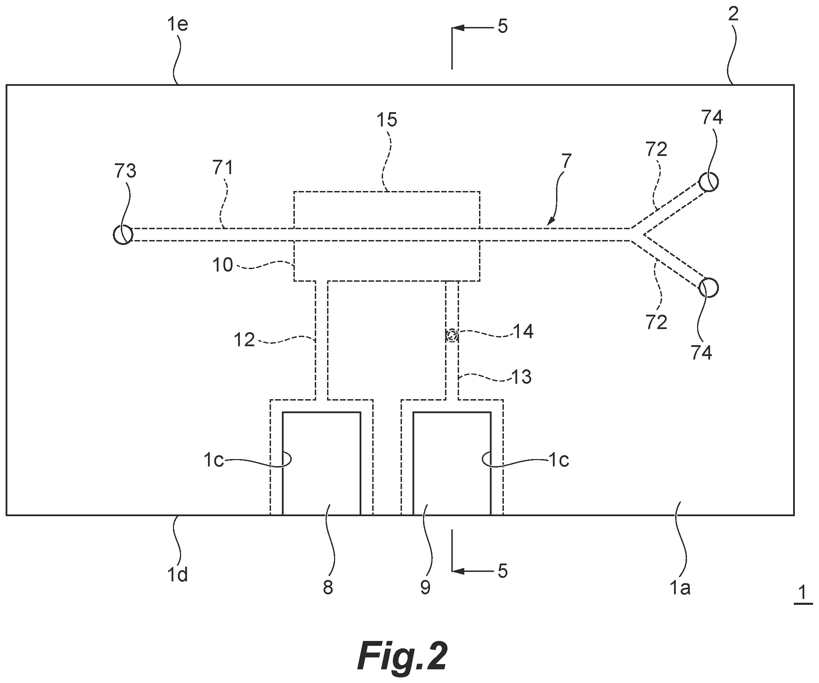

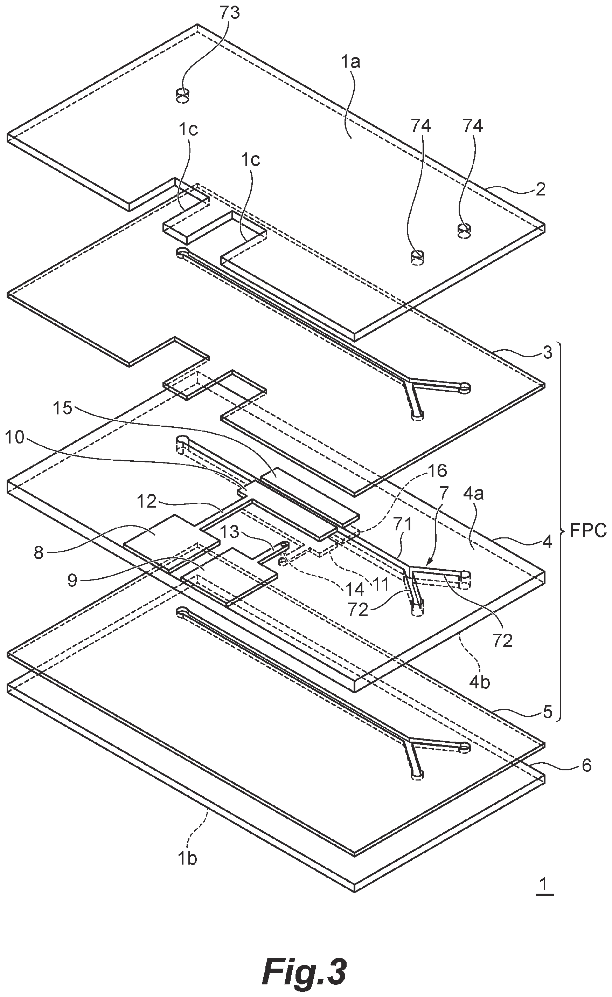

Description will be made below on an embodiment of the present invention with reference to the attached drawings. Fig. 1 is a perspective view schematically illustrating a structure of a flow path device 1 according to a first embodiment of the present invention. Fig. 2 is a plan view schematically illustrating the structure of the flow path device 1 according to the first embodiment of the present invention. Fig. 3 is an exploded perspective view schematically illustrating the structure of the flow path device 1 according to the first embodiment of the present invention. The flow path device 1 is, for example, a device for separating (sorting) substances that are specific microparticles, such as cells, from other microparticles, such as cells, using a dielectrophoretic effect. It should be noted that the terms "upper" and "lower" are used for convenience in the following description; however, these terms do not necessarily correspond to "upper" and "lower" with respect to the direction of gravity.

With reference to Fig. 1 to Fig. 3 in combination, the flow path device 1 has a stacked structure in which a plurality of layers are stacked. Specifically, the flow path device 1 has a stacked structure including, from the upper side, a first covering member 2, a first cover 3, a base 4, a second cover 5, and a second covering member 6. The first covering member 2, the first cover 3, the base 4, the second cover 5, and the second covering member 6 are bonded to one another with an adhesive or the like. The flow path device 1 is in the form of a thin plate that is, for example, rectangular in plan view, and the thin plate has a front surface 1a, which is a first surface, and a back surface 1b, which is a second surface, facing away from each other. The front surface 1a and the back surface 1b face away from each other. It should be noted that in this example, an upper surface of the flow path device 1 is defined as the front surface 1a and a lower surface of the flow path device 1 is defined as the back surface 1b for convenience; however, the definitions may be reversed.

The first covering member 2, the first cover 3, the base 4, the second cover 5, and the second covering member 6 are all made of a flexible transparent material. In this example, the first covering member 2 and the second covering member 6 are made of a resin material such as polydimethylsiloxane (PDMS). The base 4, the first cover 3, and the second cover 5 are all made of a resin material such as polyimide. The base 4, the first cover 3, and the second cover 5 provide a flexible printed circuit board (FPC). A thickness of the FPC is set to, for example, 100 µm, approximately. The flow path device 1 has flexibility as a whole.

The flow path device 1 has a flow path 7 for flowing a sample solution in which substances are suspended and the substances are microparticles. The flow path 7 extends inside the flow path device 1 along the front surface 1a and the back surface 1b. In this example, the flow path 7 includes a first flow path portion 71 linearly extending from one end to the other end thereof, and a pair of second flow path portions 72, 72 each connected to the other end of the first flow path portion 71 at one end thereof. The second flow path portions 72, 72 are bifurcated from the other end of the first flow path portion 71, linearly extending to the respective other ends thereof while getting spaced from each other. The flow path 7 is formed in the first cover 3, the base 4, and the second cover 5, and has an upper surface covered by the first covering member 2 and a lower surface covered by the second covering member 6 as described later.

A flow path inlet 73 is formed at the one end of the first flow path portion 71, and the flow path inlet 73 is open on the front surface 1a of the flow path device 1. A flow path outlet 74 is formed at the other end of each of the second flow path portions 72, and the flow path outlet 74 is open on the front surface 1a of the flow path device 1. In separating the substance, which is a microparticle such as a cell, suspended in the sample solution, the sample solution is introduced into the flow path 7 through the flow path inlet 73 as described later. The sample solution having flowed through the flow path 7 at a predetermined flow velocity is collected through the two flow path outlets 74. A pair of first conductive pad 8 and second conductive pad 9 for applying a voltage to a later-described electrode are exposed on the front surface 1a of the flow path device 1. The first conductive pad 8 and the second conductive pad 9 are exposed in, for example, respective notches 1c formed in the front surface 1a of the flow path device 1. The notches 1c are formed in the first covering member 2 and the first cover 3 (see Fig. 3).

As is apparent from Fig. 3, the flow path 7 is formed such that it penetrates the base 4, the first cover 3, and the second cover 5. That is to say, the flow path 7 penetrates from a front surface to a back surface of the FPC formed by the base 4, the first cover 3, and the second cover 5. The front surface and the back surface of the FPC are covered by the first covering member 2 and the second covering member 6, respectively. As a result, the upper surface and the lower surface of the flow path 7 are defined by the first covering member 2 and the second covering member 6, respectively. In this example, the flow path 7 extends, for example, in parallel with side surfaces 1d, 1e on the long sides of the flow path device 1 (see Fig. 2). The first covering member 2 is formed with the flow path inlet 73 and the flow path outlets 74. In contrast, the second closing member 6 is formed with neither the flow path inlet 73 nor the flow path outlets 74.

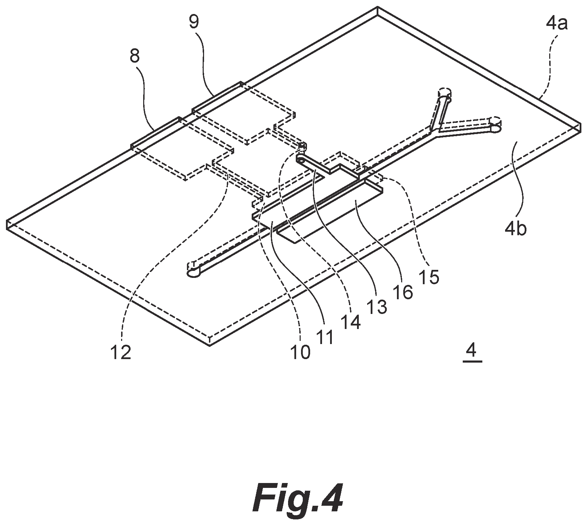

Fig. 4 is a perspective view of the base 4 alone as viewed from a back surface side of the base 4. Referring to Fig. 2 to Fig. 4 in combination, the base 4 is in the form of a thin plate having a front surface 4a and a back surface 4b facing away from each other. In this example, the front surface 4a and the back surface 4b extend in parallel with each other. The front surface 4a of the base 4 is formed with the above-described first conductive pad 8 and the second conductive pad 9. In this example, the first conductive pad 8 and the second conductive pad 9 are exposed on the side surface 1d on the long side of the base 4 (see Fig. 1). The first conductive pad 8 is electrically connected to a first electrode 10 likewise formed on the front surface 4a of the base 4. In contrast, the second conductive pad 9 is electrically connected to a second electrode 11 formed on the back surface 4b of the base 4.

To electrically connect the first conductive pad 8 and the first electrode 10, a first conductive pattern 12 extending along the front surface 4a of the base 4 is used. To electrically connect the second conductive pad 9 and the second electrode 11, a second conductive pattern 13 extending along the front surface 4a and the back surface 4b of the base 4 is used. After extending from the second conductive pad 9 along the front surface 4a, the second conductive pattern 13 extends through a through-hole via 14 penetrating the base 4 and along the back surface 4b to be connected to the second electrode 11. In a plan view of the base 4, the first electrode 10 and the second electrode 11 are disposed at positions corresponding to each other. In this example, the first electrode 10 and the second electrode 11 are disposed at the same position and have the same outline in plan view.

The front surface 4a of the base 4 is further formed with a first dummy electrode 15 corresponding to the first electrode 10. Likewise, the back surface 4b of the base 4 is formed with a second dummy electrode 16 corresponding to the second electrode 11. The first dummy electrode 15 is opposed to the first electrode 10 with the flow path 7 in between. The second dummy electrode 16 is opposed to the second electrode 11 with the flow path 7 in between. The first dummy electrode 15 and the second dummy electrode 16 are not connected to a conductive pattern. It should be noted that the first conductive pad 8, the second conductive pad 9, the first electrode 10, the second electrode 11, the first conductive pattern 12, the second conductive pattern 13, the through-hole via 14, the first dummy electrode 15, and the second dummy electrode 16 are all made of a conductive material such as copper.

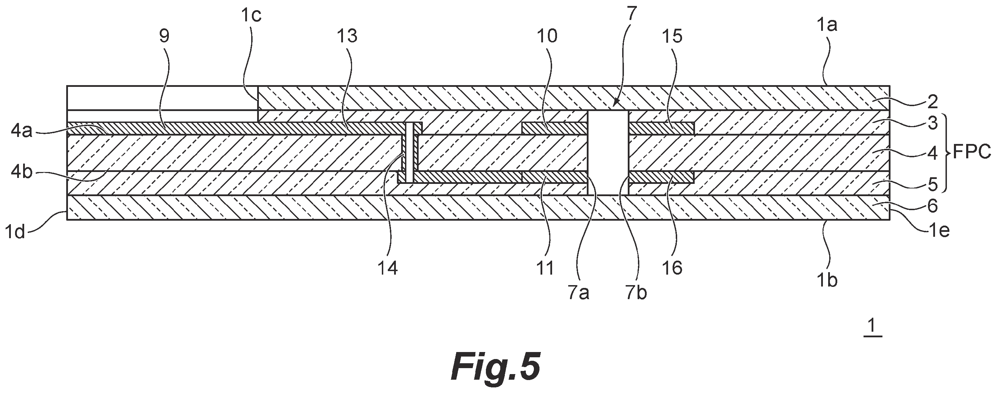

Fig. 5 is an end view of a cross section taken along a 5-5 line in Fig. 2. As illustrated in Fig. 5, the first electrode 10 and the second electrode 11 are disposed opposite in a direction in which the front surface 4a and the back surface 4b of the base 4 face away, in this example, in a thickness direction of the base 4 defined by the front surface 4a and the back surface 4b of the base 4. The thickness direction is perpendicular to the front surface 4a and the back surface 4b of the base 4. The first electrode 10 and the second electrode 11 face one side surface 7a of the flow path 7. Moreover, the first electrode 10 and the second electrode 11 face the flow path 7 over the same length in a length direction of the flow path 7 (see Fig. 2 to Fig. 4). In contrast, the first dummy electrode 15 and the second dummy electrode 16 face the other side surface 7b of the flow path 7 as illustrated in Fig. 5. In this example, the side surface 7a and the side surface 7b are defined as being parallel with each other.

The first conductive pad 8 and the second conductive pad 9 are connected to a power supply (not illustrated). The power supply is an alternating-current power supply capable of applying, for example, a voltage with a variable voltage value at a variable frequency between the first electrode 10 and the second electrode 11. The first electrode 10 is a voltage-applied electrode, whereas the second electrode 11 is a ground electrode. An electric field is formed between the first electrode 10 and the second electrode 11 by applying a voltage between the first electrode 10 and the second electrode 11 as described later. The formation of the electric field makes it possible to exert a dielectrophoretic effect on the sample solution flowing through the flow path 7.

It should be noted that the flow path device 1 includes an imaging device (not illustrated) and a light source (not illustrated). For example, both the imaging device and the light source may be disposed opposite the front surface 1a of the flow path device 1 or may be opposed to the back surface 1b. The imaging device is able to capture an image of the flow path 7 illuminated by the light source. For example, fluorescent observation of the substances may be performed by fluorescently staining the substances flowing through the flow path 7 in advance and observing fluorescence emitted from the substances under illumination from the light source. It should be noted that the imaging device may be disposed opposite the front surface 1a, whereas the light source may be disposed opposite the back surface 1b. Conversely, the imaging device may be disposed opposite the back surface 1b, whereas the light source may be disposed opposite the front surface 1a.

Next, description will be made on a mode of using the flow path device 1. For example, a sample solution is prepared, and the sample solution contains substances that are, for example, two types of microparticles such as cells with different permittivities and a solution for suspending the substances. It should be noted that in order to adjust the permittivity of the solution, the solution may be mixed with a buffer solution at a predetermined concentration. The prepared sample solution is injected through the flow path inlet 73. The sample solution is extracted from the flow path outlets 74 by, for example, negative pressure. As a result, the sample solution flows through the flow path 7 at a predetermined flow velocity. At this time, a voltage with a predetermined voltage value is applied between the first electrode 10 and the second electrode 11 at a predetermined frequency. The application of the voltage causes an electric field to be formed in the flow path 7 adjacent to the first electrode 10 and the second electrode 11 between the first electrode 10 and the second electrode 11. At this time, an image of the flow path 7 illuminated by the light source is captured by the imaging device.

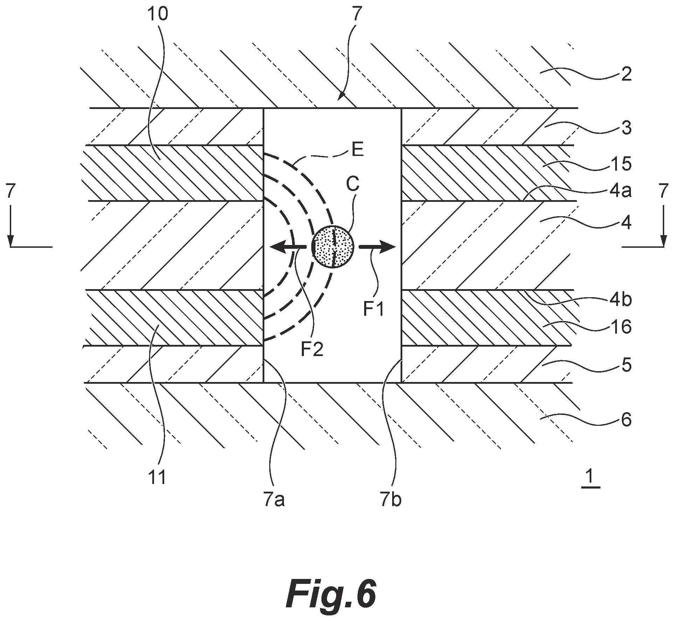

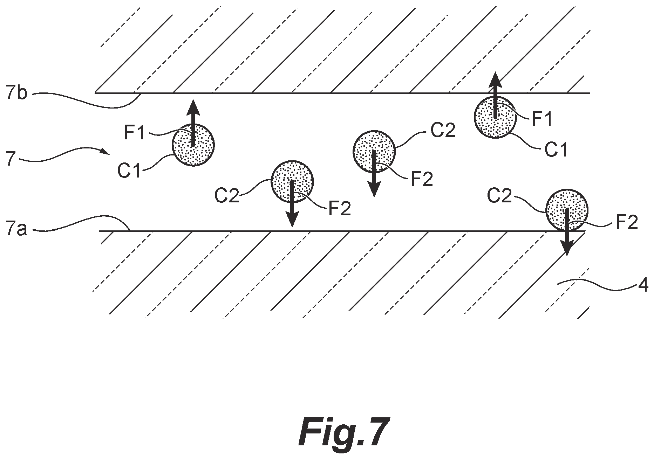

Fig. 6 is a partial enlarged cross-sectional view of the flow path device 1, schematically illustrating an appearance of the electric field formed in the flow path 7. Fig. 7 is a cross-sectional view taken along a line 7-7 in Fig. 6. As illustrated in Fig. 6, an electric field E is formed in the flow path 7 by applying a voltage between the first electrode 10 and the second electrode 11. In the flow path device 1, the electric field E intersecting the flow path 7 along the direction in which the front surface 4a and the back surface 4b of the base 4 face away, that is, a thickness direction of the flow path 7, is formed. As a result, in the sample solution flowing along the flow path 7 from the flow path inlet 73 toward the flow path outlets 74 at the predetermined flow velocity, the electric field E causes a repulsive force F1 (a negative dielectrophoresis) to be exerted on a substance C1 that is a microparticle such as a cell having a lower permittivity than the solution, while causing an attractive force F2 (a positive dielectrophoresis) to be exerted on a substance C2 that is a microparticle such as a cell having a higher permittivity than the solution as illustrated in Fig. 7.

As a result, in the sample solution flowing through the flow path 7 at a region adjacent to the first electrode 10 and the second electrode 11, the substance C1 having a lower permittivity than the solution moves to the side surface 7b side of the flow path 7, whereas the substance C2 having the higher permittivity than the solution moves to the side surface 7a side of the flow path 7. The substances C1, C2 having passed through the region adjacent to the first electrode 10 and the second electrode 11 thus separately flow into one of the second flow path portions 72 and the other second flow path portion 72, respectively, due to a difference in permittivity. The substance C1 on the side surface 7b side of the flow path 7 is extracted through the flow path outlet 74 of the one second flow path portion 72 continuous with the side surface 7b side. Simultaneously, the substance C2 having moved to the side surface 7a side of the flow path 7 is extracted through the flow path outlet 74 of the other second flow path portion 72 continuous with the side surface 7a side. As a result, the substance C1 is separated from the substance C2 by a dielectrophoretic effect.

According to the flow path device 1 as described above, the first electrode 10 and the second electrode 11 are disposed opposite in the thickness direction of the flow path 7 while being adjacent to the flow path 7. As a result, the electric field E intersecting the flow path 7 along the thickness direction of the flow path 7 is formed between the first electrode 10 and the second electrode 11. Since the first electrode 10 and the second electrode 11 are both disposed opposite along the flow path 7, it is possible to always form the constant electric field E over a relatively long range along the flow path 7. Therefore, it is possible to more reliably separate the substances C even though a force generated by the electric field E is small. Moreover, it is possible to more reliably separate the substances C even though the flow velocity of the sample solution is high.

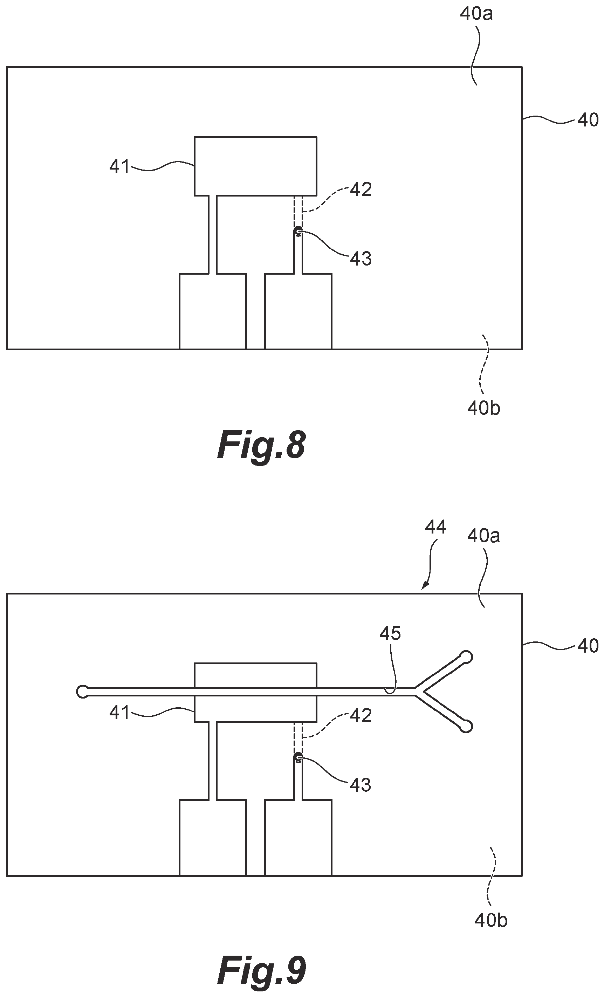

Next, description will be made on a method of manufacturing the flow path device 1 according to an embodiment of the present invention. Fig. 8 and Fig. 9 schematically illustrate the method of manufacturing the flow path device 1 according to an embodiment of the present invention. As illustrated in Fig. 8, a first conductive region 41 is formed on a surface 40a of a polyimide thin plate 40 configured to serve as the base 4. The first conductive region 41 forms a first circuit pattern conforming to outlines of the first conductive pad 8, the second conductive pad 9, the first electrode 10, the first conductive pattern 12, a portion of the second conductive pattern 13, and the first dummy electrode 15. Likewise, a second conductive region 42 is formed on a back surface 40b of the thin plate 40. The second conductive region 42 forms a second circuit pattern conforming to outlines of the second electrode 11, a portion of the second conductive pattern 13, and the second dummy electrode 16.

For example, in forming the first conductive region 41, a copper foil layer is bonded to the front surface 40a of the thin plate 40. A photoresist layer is stacked on the copper foil layer. A predetermined region of the photoresist layer is irradiated with, for example, ultraviolet light. At the irradiated region, the photoresist layer is cured by exposure to light. An uncured region of the photoresist layer is removed. Subsequently, the copper foil layer at the region other than the cured photoresist layer is removed by, for example, chemical etching. Subsequently, the photoresist layer is removed. The first conductive region 41 is formed on the front surface 40a of the thin plate 40 in this manner. It should be noted that the second conductive region 42 is also formed on the back surface 40b of the thin plate 40 in a similar method.

A region of the front surface 40a and a region of the back surface 40b serving as the second conductive pattern 13 are electrically connected through a through-hole via 43. In forming the through-hole via 43, for example, a through hole is formed at, within the front surface 40a and the back surface 40b of the thin plate 40, regions in which the first conductive region 41 and the second conductive region 42 overlap. Subsequently, the through hole is subjected to, for example, plating or the like to form the through-hole via 43. After the first conductive region 41 and the second conductive region 42 are formed, a polyimide cover (not illustrated) is attached to each of the front surface 40a and the back surface 40b of the thin plate 40 with an adhesive or the like. The covers serve as the first cover 3 and the second cover 5. An FPC 44 is manufactured in this manner.

As illustrated in Fig. 9, the FPC 44 is subjected to, for example, a laser ablation process. Specifically, a laser beam is applied to the FPC 44 along a pattern conforming to the flow path 7 at a region crossing the first conductive region 41 and the second conductive region 42. As a result, polyimide and copper at the region irradiated with the laser beam melt and evaporate. As a result, a pattern 45 conforming the flow path 7 is cut out in the FPC 44. The pattern 45 penetrates from the front surface 40a to the back surface 40b. After that, a thin plate of PDMS (not illustrated) is attached to each of the front surface 40a and the back surface 40b. It should be noted that the thin plate to be attached to the front surface 40a is provided with a through hole corresponding to each of the flow path inlet 73 and the flow path outlets 74 in advance. The thin plates serve as the first covering member 2 and the second covering member 6. The flow path device 1 is manufactured in this manner.

According to the manufacturing method as described above, the pattern 45 conforming to the flow path 7 is cut out in the FPC 44 at the region crossing the first conductive region 41 and the second conductive region 42 formed on the front surface 40a and the back surface 40b of the thin plate 40. By the cutting out, the first electrode 10 and the second electrode 11 and the first dummy electrode 15 and the second dummy electrode 16 are simultaneously formed on both sides of the pattern 45 on the front surface 4a and the back surface 4b of the base 4. The first electrode 10 and the second electrode 11 facing the pattern 45 are formed at the same time as the formation of the pattern 45, which eliminates the necessity for high-precision positioning of the first electrode 10 and the second electrode 11 relative to the flow path 7.

According to such a manufacturing method, the electrodes 10 and 11 are formed at the same time as the formation of the flow path 7, which makes it possible to reduce the number of manufacturing steps. The reduction in the number of manufacturing steps makes it possible to improve an efficiency in manufacturing the flow path device 1. As a result, mass production of the flow path device 1 can be facilitated. Moreover, the flow path device 1 includes the FPC 44, which makes it possible to manufacture the flow path device 1 at lower cost as compared with a case where it is manufactured from a glass or the like. It should be noted that the first dummy electrode 15 and the second dummy electrode 16 do not necessarily have to be formed. That is to say, the electrodes 10 and 11 may be formed by cutting out the pattern 45 along edges of the first conductive region 41 and the second conductive region 42.

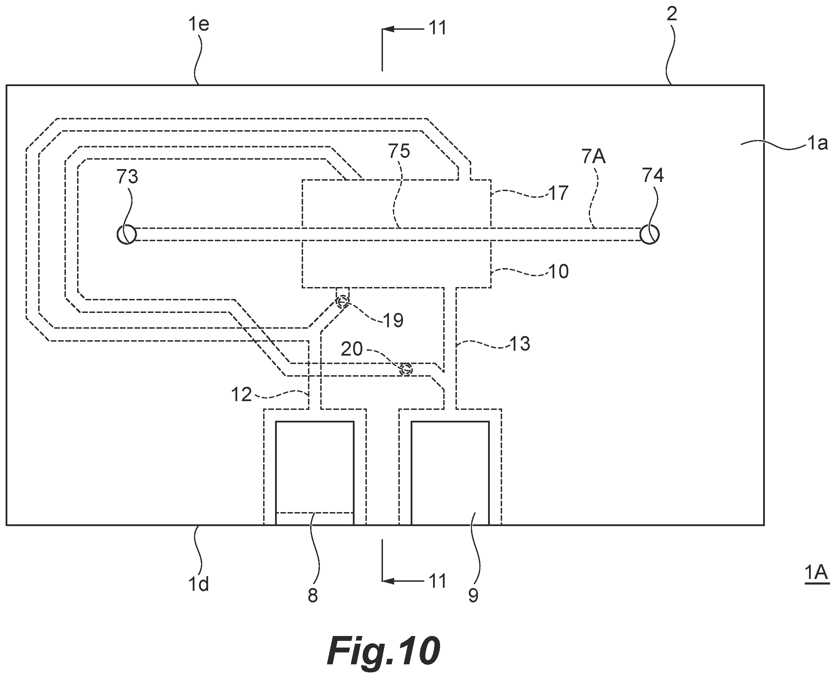

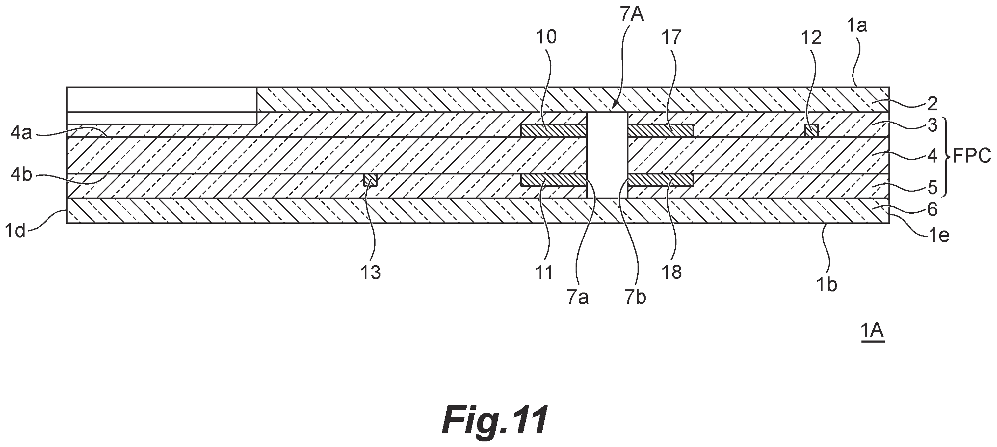

Fig. 10 is a plan view schematically illustrating a structure of a flow path device 1A according to a second embodiment of the present invention. Fig. 11 is an end view of a cross section taken along an 11-11 line in Fig. 10. Unlike the flow path device 1 according to the first embodiment, the flow path device 1A is a device for, for example, aligning (focusing) substances by a dielectrophoretic effect, and the substances are specific microparticles such as cells.

As illustrated in Fig. 10 and Fig. 11, the flow path device 1A according to the second embodiment has a stacked structure including the first covering member 2, the first cover 3, the base 4, the second cover 5, and the second covering member 6 as the flow path device 1 according to the first embodiment. The flow path device 1A has a flow path 7A having a different shape from that of the above-described flow path device 1, and further includes a third electrode 17 and a fourth electrode 18 in place of the first dummy electrode 15 and the second dummy electrode 16 of the above-described flow path device 1. Except as described above. the same reference numerals are assigned to components similar to those of the flow path device 1 according to the first embodiment, and the redundant descriptions are omitted here, accordingly.

The flow path 7A has a third flow path portion 75 linearly extending along the front surface 1a and the back surface 1b of the flow path device 1. The flow path inlet 73 is formed at one end of the third flow path portion 75 and the flow path outlet 74 is formed at the other end of the third flow path portion 75. In this example, the flow path 7A also extends along the side surfaces 1d, 1e on the long sides of the flow path device 1. The flow path device 1A is structurally similar to the flow path device 1 according to the first embodiment in that: the flow path 7A penetrates the base 4, the first cover 3, and the second cover 5, that is, from the front surface to the back surface of the FPC; an upper surface and a lower surface of the flow path 7A are closed by the first covering member 2 and the second covering member 5, respectively; and the first covering member 2 is formed with the flow path inlet 73 and the flow path outlet 74.

The third electrode 17 is formed on the front surface 4a of the base 4 and opposed to the first electrode 10 with the flow path 7A in between. The fourth electrode 18 is formed on the back surface 4b of the base 4 and opposed to the second electrode 11 with the flow path 7A in between. The third electrode 17 and the fourth electrode 18 are disposed opposite in the thickness direction of the base 4. The third electrode 17 and the fourth electrode 18 face the other side surface 7b of the flow path 7. Moreover, the third electrode 17 and the fourth electrode 18 face the flow path 7A over the same length in a length direction of the flow path 7A. Likewise, the third electrode 17 and the fourth electrode 18 face the flow path 7A over the same length as the first electrode 10 and the second electrode 11 in the length direction of the flow path 7A.

In the second embodiment, the first conductive pad 8 is electrically connected to the second electrode 11 and the third electrode 17 through the first conductive pattern 12. For the electrical connection between the first conductive pad 8 and the second electrode 11, the first conductive pattern 12 extends between the front surface 4a and the back surface 4b of the base 4 through a through-hole via 19. In contrast, the second conductive pad 9 is electrically connected to the first electrode 10 and the fourth electrode 18 through the second conductive pattern 13. For the electrical connection between the second conductive pad 9 and the fourth electrode 18, the second conductive pattern 13 extends between the front surface 4a and the back surface 4b of the base 4 through a through-hole via 20. In this example, the second electrode 11 and the third electrode 17 are voltage-applied electrodes, and the first electrode 10 and the fourth electrode 18 are ground electrodes.

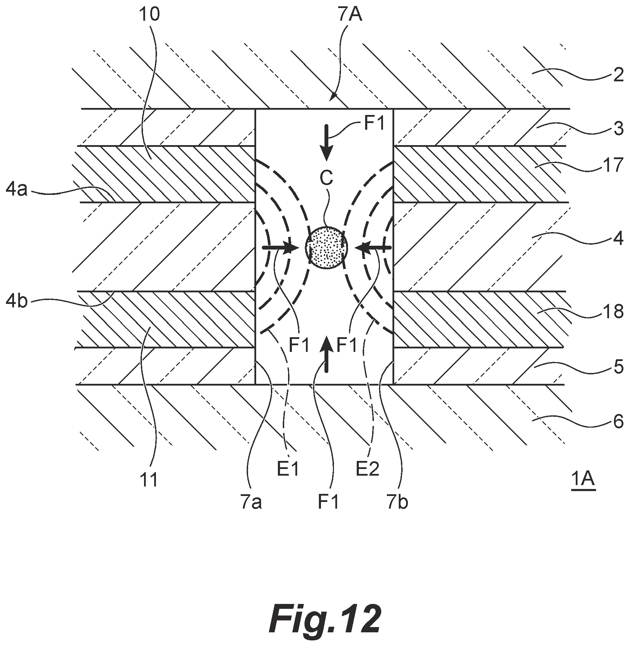

Fig. 12 is a partial enlarged cross-sectional view of the flow path device 1A, schematically illustrating an appearance of an electric field formed in the flow path 7A. In the flow path device 1A, a sample solution contains a solution and substances C suspended in the solution. The substances C have a smaller permittivity than that of the solution and are, for example, a plurality of types of microparticles, such as cells. When a predetermined voltage is applied between the first electrode 10 and the second electrode 11 and between the third electrode 17 and the fourth electrode 18, an electric field is formed in the flow path 7A. In this flow path device 1A, electric fields E1, E2 intersecting the flow path 7A along a thickness direction of the flow path 7A are formed. Specifically, at the same time as the electric field E1 is formed between the first electrode 10 and the second electrode 11 on the side surface 7a of the flow path 7A, the electric field E2 is formed between the third electrode 17 and the and the fourth electrode 18 on the side surface 7b.

In this case, according to a simulation performed using finite element analysis (FEA) software by the inventors, it has been demonstrated that the electric fields E1, E2 cause the repulsive force F1 (the negative dielectrophoresis) to be exerted toward not only a center in a width direction of flow path 7A (a direction that is parallel with the front surface 1a and the back surface 1b and perpendicular to the length direction of the flow path 7A) but also a center in the thickness direction of the flow path 7A (a direction perpendicular to the front surface 1a and the back surface 1b). That is to say, the substances C in the flow path 7A receive the repulsive force F1 so that the substances C move toward the centers in both the thickness direction and the width direction of the flow path 7A. As a result, the substances C are aligned on the centers in the thickness direction and the width direction of the flow path 7A. Focusing is thus performed in the flow path device 1A. It should be noted that the flow path device 1A is manufactured by a similar manufacturing method to that of the flow path device 1. Accordingly, the redundant description is omitted here.

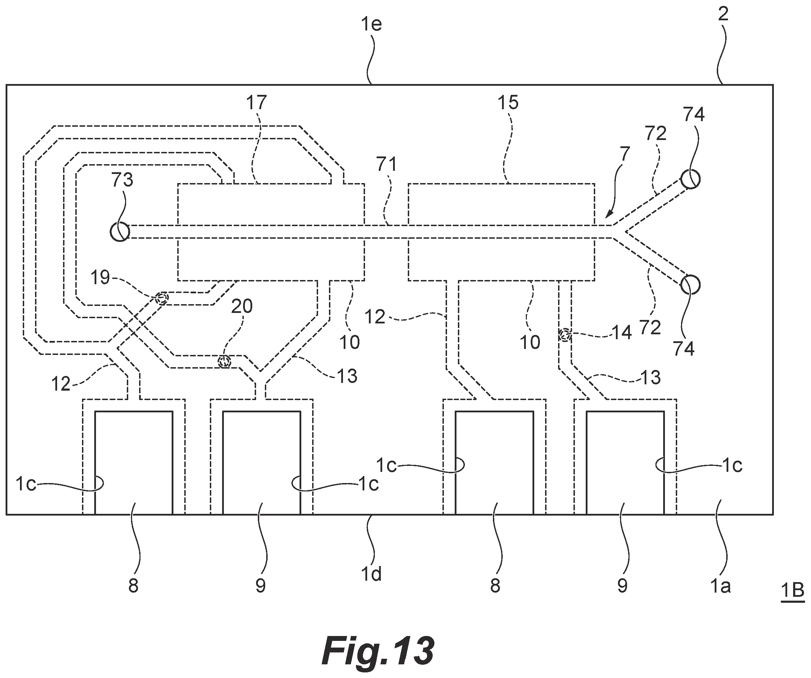

Fig. 13 is a plan view schematically illustrating a structure of a flow path device 1B according to a third embodiment of the present invention. The flow path device 1B according to the third embodiment has a structure of a combination of the flow path device 1 according to the first embodiment and the flow path device 1A according to the second embodiment. The flow path device 1B has the flow path 7 of the flow path device 1 according to the first embodiment. The configuration of the flow path device 1A is established at the flow path inlet 73 side of the flow path 7 and the configuration of the flow path device 1 is established at the flow path outlet 74 side. That is to say, the configuration of the flow path device 1A and the configuration of the flow path device 1 are arranged along the flow path 7. Except as described above, the same reference numerals are assigned to components similar to those of the flow path device 1 according to the first embodiment and the flow path device 1A according to the second embodiment, and the redundant descriptions are omitted here, accordingly.

In the flow path device 1B, the first electrode 10, the second electrode 11, the third electrode 17, and the fourth electrode 18 of the flow path device 1A are disposed adjacent to the flow path 7 upstream of the first flow path portion 71. Further, the first electrode 10, the second electrode 11, the first dummy electrode 15, and the second dummy electrode 16 of the flow path device 1 are disposed adjacent to the flow path 7 downstream of the first flow path portion 71. It should be noted that an electrical connection relationship is similar to those of the first embodiment and the second embodiment, although that pattern shapes of the first conductive pattern 12 and the second conductive pattern 13 illustrated in Fig. 13 are different from those of the first embodiment and the second embodiment. It should be noted that the flow path device 1B is manufactured by a similar manufacturing method to that of the flow path device 1. Accordingly, the redundant description is omitted here.

In such a flow path device 1B, a sample solution prepared such that substances, which are microparticles such as cells, and a solution have permittivities as described above is flowed through the flow path 7. Moreover, a voltage having a voltage value and a frequency as described above is applied between the electrodes at each of the region of the flow path device 1A and the region of the flow path device 1. As a result, the substances having passed through the region of the flow path device 1A upstream of the flow path 7 are aligned (focused) on the centers in the thickness direction and the width direction of the flow path 7. After passing through the region of the flow path device 1 downstream of the flow path 7, the substances aligned on the centers of the flow path 7 are separated (sorted) from each other as moving toward the side surface 7a and the side surface 7b of the flow path 7 on the basis of a difference in permittivity. The substances thus separated from each other are extracted from the flow path outlets 74 through the respective second flow path portions 72.

In such a flow path device 1B, the substances having passed through the region of the flow path device 1A are aligned on the centers in the thickness direction and the width direction of the flow path 7 by the repulsive force (the negative dielectrophoresis) generated by the electric fields between the electrodes of the flow path device 1A. As the substances thus aligned pass through the region of the flow path device 1, the attractive force (the positive dielectrophoresis) and the repulsive force (the negative dielectrophoresis) can be uniformly exerted on the substances at the region of the flow path device 1. As a result, after passing through the region of the flow path device 1, one of the substances is separated from the other substance. The attractive force and the repulsive force are uniformly exerted on the aligned substances, which makes it possible to significantly improve an accuracy in separating the substances at the region of the flow path device 1.

In the above-described flow path devices 1, 1A, 1B, the first electrode 10, the second electrode 11, the third electrode 17, and the fourth electrode 18 face the side surface 7a or the side surface 7b of the flow path 7 or 7A. However, the first electrode 10, the second electrode 11, the third electrode 17, and the fourth electrode 18 may be disposed at positions retreated from the side surface 7a or the side surface 7b of the flow path 7 or 7A along the front surface 4a or the back surface 4b of the base 4, as long as an electric field required for a dielectrophoretic effect can be formed in the flow path 7 or 7A. That is to say, the first electrode 10, the second electrode 11, the third electrode 17, and the fourth electrode 18 may be opposed to the side surface 7a or the side surface 7b of the flow path 7 or 7A at a predetermined distance.

Although the present invention is described with reference to the above embodiments, the technical scope of the present invention is not limited to those described in the above embodiments. It is obvious to those skilled in the art that various modifications or improvements may be added to the above embodiments. It is obvious from the description of the claims that embodiments added with such modifications or improvements are also within the technical scope of the present invention.

The embodiments described above are intended to facilitate the understanding of the present invention but not intended for a limited interruption of the present invention. Furthermore, the above-described embodiments are not intended to limit an application target for which the present invention is to be applied and the present invention may encompass, as the application target, any and all objects. The components of the above-described embodiments and the locations, materials, conditions, shapes, sizes, and the like thereof are not limited to those described by way of example and may be modified, if necessary.

For example, the present invention encompasses a difference generated in implementation, such as a manufacturing tolerance. Furthermore, within the scope of technical consistency, the components described in different embodiments may be partially replaced or combined. Furthermore, the configurations may be selectively combined, if necessary, to achieve at least some of the problems and the effects described above.

### REFERENCE SIGNS LIST

1, 1A, 1B flow path device, 1a first surface (front surface), 1b second surface (back surface), 1c notch, 1d, side surface, 1e side surface, 2 first covering member, 3 first cover, 4 base, 4a front surface, 4b back surface, 40 thin plate, 40a front surface, 40b back surface, 41 first conductive region, 42 second conductive region, 43 through-hole via, 44 flexible printed circuit board, 45 pattern, 5 second cover, 6 second covering member, 7, 7A flow path, 7a side surface, 7b side surface, 71 first flow path portion, 72 second flow path portion, 73 flow path inlet, 74 flow path outlet, 75 third flow path portion, 8 first conductive pad, 9 second conductive pad, 10 first electrode, 11 second electrode, 12 first conductive pattern, 13 second conductive pattern, 14 through-hole via, 15 first dummy electrode, 16 second dummy electrode, 17 third electrode, 18 fourth electrode, C, C1, C2 substance, E, E1, E2 electric field, F1 repulsive force (negative dielectrophoresis), F2 attractive force (positive dielectrophoresis)

## Claims

1. A flow path device comprising:
a base having a first surface and a second surface facing away from each other; and
a pair of a first electrode and a second electrode, wherein
the base has a flow path extending along the first surface and the second surface, and
the pair of the first electrode and the second electrode form an electric field intersecting the flow path along a direction in which the first surface and the second surface face away.

2. The flow path device according to claim 1, wherein
the first electrode extends along the flow path on a side of the first surface, and
the second electrode extends along the flow path on a side of the second surface.

3. The flow path device according to claim 2, wherein
the first electrode is formed on the first surface and faces the flow path, and
the second electrode is formed on the second surface and faces the flow path.

4. The flow path device according to claim 3, comprising:
a third electrode formed on the first surface, the third electrode facing the flow path while being opposed to the first electrode with the flow path in between; and
a fourth electrode formed on the second surface, the fourth electrode facing the flow path while being opposed to the second electrode with the flow path in between.

5. The flow path device according to claim 1, comprising:
a first covering member provided on the first surface to cover the flow path; and
a second covering member provided on the second surface to cover the flow path.

6. The flow path device according to claim 1, wherein the flow path includes a first flow path portion extending linearly.

7. The flow path device according to claim 1, wherein the flow path includes a first flow path portion extending linearly, and a pair of second flow path portions branched from the first flow path portion.

8. The flow path device according to claim 1, wherein the flow path is exposed on each of the first surface and the second surface of the base.

9. The flow path device according to any one of claims 1 to 8, wherein the base and the pair of the first electrode and the second electrode provide a flexible printed circuit board.

10. A method of manufacturing a flow path device, the method including:
forming a first conductive region on a first surface of a base, the base having the first surface and a second surface;
forming a second conductive region on the second surface at a position corresponding to the first conductive region; and
cutting out a flow path in the base at the first conductive region and the second conductive region, wherein
by the cutting out of the flow path, a first electrode facing the flow path is formed on the first surface of the base and a second electrode facing the flow path is formed on the second surface.

11. The method of manufacturing a flow path device according to claim 10, wherein by the cutting out of the flow path, a third electrode and a fourth electrode are formed on the first surface of the base and the second surface of the base, respectively, the third electrode facing the flow path while being opposed to the first electrode with the flow path in between, the fourth electrode facing the flow path while being opposed to the second electrode with the flow path in between.

12. The method of manufacturing a flow path device according to claim 10 or 11, wherein the cutting out of the flow path is performed by laser beam irradiation.
